# FASCICULE DE BREVET EUROPEEN

(11) **EP 1 798 695 B1**
(45) Date de publication et mention de la délivrance du brevet: **10.06.2009**
(21) Numéro de dépôt: 06126053.5
(22) Date de dépôt: 13.12.2006
(51) Int. Cl.: G07F 7/10, H05K 5/02, H01R 13/62

(54) **Système électronique connecté à un câble électrique à tenue en fatigue de câble améliorée**
Elektronische Vorrichtung verbunden mit einem elektrischen Kabel mit verbesserter Ermüdungsfestigkeit
Electronic device connected to an electric cable with an improved fatigue resistance

(30) Priorité: 13.12.2005 FR 0553840
(43) Date de publication de la demande: 20.06.2007
(73) Titulaire: Ingenico France, 92200 Neuilly Sur Seine (FR)
(72) Inventeur: Andre, Jérôme, 07500, GUILHERAND GRANGES (FR); Dubois, Eric, 07500, GUILHERAND GRANGES (FR); Pavageau, Stéphane, 07500, GUILHERAND GRANGES (FR)
(74) Mandataire: de Beaumont, Michel

(56) Documents cités:
- US-A- 5 378 882
- US-A- 5 898 789
- US-A1- 2005 186 834

## Description

### Domaine de l'invention

La présente invention concerne un système électronique connecté à au moins un câble électrique, et en particulier un système électronique susceptible d'être déplacé en cours d'utilisation.

### Exposé de l'art antérieur

De nombreux systèmes électroniques qui sont susceptibles d'être déplacés par un utilisateur au cours de leur utilisation sont connectés par un ou plusieurs câbles électriques à un réseau d'alimentation électrique, à un réseau de transmission de données, par exemple le réseau téléphonique, ou à un autre appareil électronique. Il s'agit, par exemple, d'un système de lecture/écriture de données sur des cartes de paiement, par exemple des cartes à puce ou des cartes magnétiques, également appelé lecteur de cartes et utilisé notamment pour réaliser des opérations de paiement. Un lecteur de cartes comprend généralement un boîtier au niveau duquel sont prévus un écran d'affichage, un clavier, des moyens de réception d'une carte de paiement et au moins deux bornes de connexion pour relier respectivement le lecteur au réseau d'alimentation électrique et au réseau téléphonique. De plus, le boîtier contient des circuits électroniques permettant la lecture et l'écriture de données sur la carte de paiement et l'échange de données avec le réseau de transmission de données. Les bornes de connexion du lecteur sont reliées au réseau d'alimentation électrique et au réseau téléphonique par des câbles électriques, chaque câble comprenant un ou plusieurs fils conducteurs protégés par une gaine isolante. Pour certaines opérations particulières, le lecteur peut comprendre d'autres types de bornes de connexion, par exemple une borne série RS232 ou une borne USB (acronyme anglais pour Universal Serial Bus) permettant la transmission de données par une liaison série. De façon générale, les bornes sont placées au niveau de la face arrière du lecteur et chaque câble comprend, à une extrémité, une fiche adaptée permettant de le connecter dans la borne correspondante.

Un lecteur de cartes de paiement subit des manipulations fréquentes. En effet, lors d'une opération de paiement, le commerçant prend en main le lecteur, disposé initialement sur un support, par exemple une table, pour indiquer le montant du paiement au moyen du clavier du lecteur. Le commerçant donne alors le lecteur au client qui valide l'opération de paiement, éventuellement en tapant le code d'identification de la carte de paiement. A la fin de l'opération de paiement, le lecteur est reposé sur son support.

Toutes ces manipulations se traduisent par l'application répétée d'efforts aux câbles électriques. En effet, à chaque fois que l'utilisateur soulève le lecteur de son support et l'incline pour taper des données sur le clavier ou lire des données affichées sur l'écran, des efforts de traction et de flexion sont appliqués aux câbles électriques au niveau des connexions entre les câbles et le lecteur. Ceci peut entraîner une détérioration rapide des câbles électriques.

En outre, un lecteur de cartes de paiement peut comprendre un rouleau de papier sur lequel sont imprimées les données relatives à l'opération de paiement en cours. Le rouleau de papier est généralement protégé par un couvercle pivotant. Pour accéder au rouleau de papier, par exemple pour remplacer un rouleau usagé par un nouveau rouleau, on fait pivoter le couvercle du lecteur. Afin de ne pas gêner l'accès au clavier et à l'écran d'affichage, le rouleau de papier est généralement situé à proximité de la face arrière du lecteur et le couvercle de protection du rouleau est fixé au lecteur par une liaison pivotante de sorte que le couvercle est pivoté vers l'arrière du lecteur. Les bornes de connexion doivent alors être suffisamment éloignées du couvercle de protection pour que la présence des câbles ne gène pas l'ouverture du couvercle. Ceci peut conduire à un lecteur dont la partie arrière a des dimensions importantes. Ceci va à l'encontre de la tendance actuelle qui consiste à réaliser des lecteurs ayant les plus petites dimensions possibles pour en faciliter la manipulation.

Le document US 5 378 882 décrit un système électronique comprenant un boîtier, une borne de connexion disposée au niveau du boîtier, un câble électrique ayant une extrémité électriquement connectée à la borne de connexion et un dispositif de liaison mécanique du câble électrique au boîtier.

### Résumé de l'invention

La présente invention vise à réduire les efforts exercés sur un câble électrique connecté à un système électronique lors d'une manipulation du système électronique.

Un autre objet de la présente invention est de réduire l'encombrement du système électronique au niveau de la liaison entre le système électronique et le câble électrique.

Pour atteindre ces objets, la présente invention prévoit un système électronique comprenant un boîtier ; une borne de connexion disposée au niveau du boîtier ; un câble électrique ayant une extrémité électriquement connectée à la borne de connexion ; et un dispositif de liaison mécanique du câble électrique au boîtier, solidaire du câble électrique et relié au boîtier selon au moins une liaison pivotante.

Selon un exemple de réalisation de la présente invention, le câble électrique comprend une première portion de câble ayant une première extrémité reliée au dispositif de liaison et une seconde extrémité reliée à la borne de connexion ; une deuxième portion de câble ayant une troisième extrémité reliée au dispositif de liaison ; et au moins un fil conducteur s'étendant dans la première portion de câble, le dispositif de liaison et la deuxième portion de câble, le système électronique comprenant en outre au moins un câble électrique supplémentaire comprenant une troisième portion de câble ayant une quatrième extrémité reliée au dispositif de liaison et une cinquième extrémité électriquement connectée à une borne de connexion supplémentaire disposée au niveau d'un boîtier ; et au moins un fil conducteur supplémentaire s'étendant dans la troisième portion de câble, le dispositif de liaison et la deuxième portion de câble.

Selon un exemple de réalisation de la présente invention, le boîtier comprend une face inférieure, la face inférieure étant destinée à être au moins en partie en contact avec un support lorsque le lecteur est déposé sur le support, une face supérieure opposée à la face inférieure, et deux faces latérales reliant la face inférieure à la face supérieure, le dispositif de liaison étant adapté à pivoter autour d'un axe perpendiculaire aux faces latérales.

Selon un exemple de réalisation de la présente invention, le dispositif de liaison comprend un corps solidaire du câble électrique et deux arbres cylindriques se projetant de part et d'autre du corps, le boîtier comprenant deux paliers, chaque palier ayant une ouverture cylindrique recevant l'un des arbres.

Selon un exemple de réalisation de la présente invention, le boîtier comprend une face inférieure, la face inférieure étant destinée à être au moins en partie en contact avec un support lorsque le lecteur est déposé sur le support, la borne de connexion étant située au niveau de la face inférieure.

La présente invention prévoit également un câble électrique destiné à être connecté à un système électronique comprenant un boîtier, le câble électrique ayant une extrémité destinée à être électriquement connectée à une borne de connexion disposée au niveau du boîtier, et comprenant un dispositif de liaison du câble électrique au système électronique, solidaire du câble électrique et comprenant un moyen de liaison mécanique destiné à être relié à un moyen de liaison mécanique complémentaire du boîtier pour former une liaison pivotante.

Selon un exemple de réalisation de la présente invention, le dispositif de liaison est constitué d'un matériau plastique et est formé par surmoulage sur le câble électrique.

Selon un exemple de réalisation de la présente invention, le dispositif de liaison comprend un corps solidaire du câble électrique et le moyen de liaison comprend deux arbres cylindriques se projetant de part et d'autre du corps.

La présente invention prévoit également un dispositif de connexion électrique, comprenant un câble électrique tel que décrit précédemment, dans lequel le câble électrique comprend une première portion de câble ayant une première extrémité reliée au dispositif de liaison et une seconde extrémité reliée à la borne de connexion ; une deuxième portion de câble ayant une troisième extrémité reliée au dispositif de liaison ; et au moins un fil conducteur s'étendant dans la première portion de câble, le dispositif de liaison et la deuxième portion de câble ; et comprenant au moins un câble électrique supplémentaire comprenant une troisième portion de câble ayant une quatrième extrémité reliée au dispositif de liaison et une cinquième extrémité destinée à être électriquement connectée à une borne de connexion supplémentaire disposée au niveau d'un boîtier ; et au moins un fil conducteur supplémentaire s'étendant dans la troisième portion de câble, le dispositif de liaison et la deuxième portion de câble.

Selon un exemple de réalisation de la présente invention, les première et troisième portions de câble sont reliées au dispositif de liaison au niveau d'une première face du dispositif de liaison et la deuxième portion de câble est reliée au dispositif de liaison au niveau d'une seconde face du dispositif de liaison opposée à la première face.

### Brève description des dessins

Ces objets, caractéristiques et avantages, ainsi que d'autres de la présente invention seront exposés en détail dans la description suivante d'exemples de réalisation particuliers faite à titre non-limitatif en relation avec les figures jointes parmi lesquelles :
la figure 1 est une vue de dessous d'un lecteur de cartes de paiement comprenant un dispositif de liaison de câbles selon un premier exemple de réalisation de l'invention ;
les figures 2 et 3 représentent schématiquement deux étapes de fabrication du dispositif de liaison de la figure 1 ;
les figures 4 et 5 illustrent le fonctionnement du dispositif de liaison de la figure 1 lors de la manipulation du lecteur et l'ouverture d'un couvercle de protection d'un rouleau de papier ; et
la figure 6 est une vue analogue à la figure 1 représentant un second exemple de réalisation du dispositif de liaison selon l'invention.

### Description détaillée

Par souci de clarté, de mêmes éléments ont été désignés par de mêmes références aux différentes figures.

La présente invention consiste, pour chaque câble électrique connecté au système électronique, à disposer la borne de connexion du câble au niveau de la face inférieure du système électronique et de relier, en outre, le câble au niveau de la partie arrière du système électronique par au moins une liaison à pivot. De ce fait, lors d'une manipulation du système électronique, le câble peut pivoter par rapport au système électronique au niveau de la liaison à pivot. On réduit alors la déformation du câble au niveau de la liaison à pivot lors d'un déplacement du système électronique et on obtient une diminution des efforts exercés sur le câble. En outre, la possibilité de faire pivoter le câble au niveau de la face arrière du système électronique permet d'écarter plus facilement le câble lors de l'ouverture du couvercle de protection du rouleau de papier d'impression même si la liaison à pivot est placée à proximité du couvercle. On peut alors réduire les dimensions de la partie arrière du système électronique.

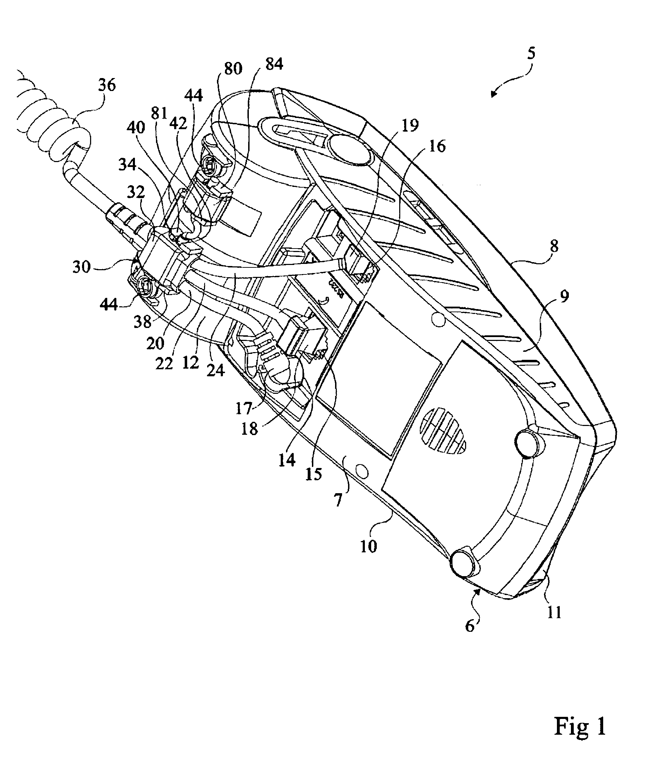

La figure 1 est une vue de dessous d'un lecteur 5 de cartes de paiement, par exemple d'un lecteur de cartes à puce, comprenant un boîtier 6 comportant une face inférieure 7, une face supérieure 8, deux faces latérales 9, 10 reliant chacune un bord latéral de la face inférieure 7 à un bord latéral de la face supérieure 8, une partie avant 11 reliant le bord avant de la face inférieure 7 au bord avant de la face supérieure 8 et une partie arrière 12 s'étendant à partir du bord arrière de la face inférieure 7 et correspondant à une portion de cylindre. Le boîtier 6 contient divers circuits électroniques, non représentés, pour réaliser des opérations de lecture/écriture sur des cartes à puce. Dans le présent exemple de réalisation, le lecteur 5 comprend trois bornes de connexion 14, 15, 16 disposées au niveau de la face inférieure 7. La borne 14 permet l'alimentation électrique des circuits électroniques contenus dans le boîtier 6. La borne 15 permet l'échange de données via un réseau d'échange d'informations. Il s'agit, par exemple, du réseau téléphonique. La borne 15 est alors reliée à un modem, non représenté, contenu dans le boîtier 6. Il peut également s'agir d'un réseau Ethernet. La borne 16 permet l'échange de données par une liaison de type série. Chaque borne 14, 15, 16 reçoit une fiche 17, 18, 19 complémentaire disposée à une extrémité d'un câble électrique 20, 22, 24. Le câble 20 correspond donc à un câble d'alimentation électrique, le câble 22 à un câble de transmission de données via le réseau d'échange d'informations, ou câble réseau 22, et le câble 24 à un câble série. Les câbles 20, 22, 24 ont une structure classique, et comprennent, par exemple, une gaine isolante entourant un ou plusieurs fils conducteurs.

Les câbles 20, 22, 24 se rejoignent au niveau d'un dispositif de liaison 30 relié de façon pivotante à la partie arrière 12 du boîtier 6. Le dispositif de liaison 30 comprend un corps 32, constitué d'un matériau isolant, et deux arbres cylindriques 34 concentriques qui se projettent de part et d'autre du corps 32. Un câble électrique unique 36 est relié au corps 32 du côté opposé aux câbles 20, 22, 24. Les fils conducteurs des câbles 20, 22, 24 se prolongent dans le dispositif de liaison 30 et ensuite dans le câble 36. Le câble 36 comprend, à l'extrémité, non représentée, opposée au dispositif de liaison 30, un bloc au niveau duquel sont disposées des fiches de connexion complémentaires des fiches 17, 18, 19 et connectées aux fils conducteurs associés s'étendant dans le câble 36. Selon une variante, le câble 36 peut, au niveau de l'extrémité opposée au dispositif de liaison 30 se séparer en trois câbles électriques correspondant aux câbles 20, 22, 24.

Le lecteur 5 comprend deux paliers 38, 40 qui se projettent de la partie arrière 12 du boîtier 6. Chaque palier 38, 40 comprend une ouverture cylindrique 42 recevant un arbre 34 du dispositif de liaison 30 et dont le diamètre est légèrement supérieur au diamètre des arbres 34. Le dispositif de liaison 30 peut donc pivoter par rapport au boîtier 6 autour de l'axe défini par les arbres 34. L'axe de pivotement du dispositif de liaison 30 est sensiblement perpendiculaire aux faces latérales 9, 10 du boîtier 6. Selon une variante de réalisation, à la place des arbres 34 et des paliers 38, 40, on prévoit des ouvertures cylindriques au niveau du dispositif de liaison 30, chaque ouverture cylindrique recevant un arbre cylindrique réalisé au niveau du boîtier 6.

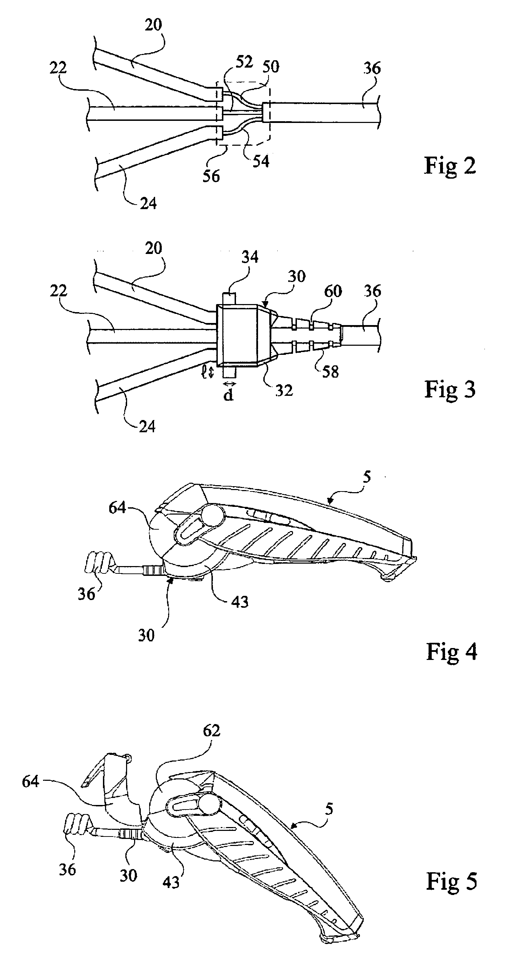

Un capot inférieur 43, représenté seulement aux figures 4 et 5, est destiné à recouvrir la partie arrière 12 et une portion de la face inférieure 7 du boîtier 6 pour protéger les câbles 20, 22, 24, les fiches 17, 18, 19 et les bornes de connexion 14, 15, 16 et permettre de poser le lecteur 5 sur une surface plane. La fixation du capot 43 au boîtier 6 est, par exemple, réalisée par l'intermédiaire de vis, des ouvertures 44 destinées à recevoir les vis étant prévues au niveau de la partie arrière 12 du boîtier 6. Il peut s'agir de vis filetées ou de vis quart de tour. Le capot inférieur 43 délimite avec le boîtier 6 une ouverture pour le passage du dispositif de liaison 30 dont les dimensions sont suffisamment importantes pour ne pas empêcher le pivotement du dispositif de liaison 30.

Les figures 2 et 3 illustrent, de façon très schématique, des étapes successives d'un exemple de procédé de fabrication du dispositif de liaison 30 de la figure 1. On réalise initialement les gaines des câbles 20, 22, 24 autour d'une première partie de fils conducteurs 50, 52, 54 et on réalise la gaine du câble 36 autour d'une seconde partie des fils conducteur 50, 52, 54. On a représenté seulement un fil conducteur par câble 20, 22, 24 sachant que plusieurs fils conducteurs peuvent être associés à chaque câble 20, 22, 24.

La première étape du procédé selon l'invention consiste à réaliser par surmoulage un bloc initial 56, représenté en traits pointillés en figure 2, qui fixe les positions relatives des fils conducteurs 50, 52, 54 et des câbles 20, 22, 24, 36. On réalise ensuite un surmoulage sur le bloc 56 pour former le corps 32 et les arbres 34. Le bloc 56, le corps 32 et les arbres 34 sont, par exemple, réalisés en PVC ou en polyuréthane. Le matériau choisi a une dureté shores A comprise entre 75 et 95, de préférence entre 80 et 92. Il peut également être réalisé, à cette étape, un passe fil 58 qui prolonge le corps 32 au niveau du câble 36. Le passe-fil 58 est constitué d'un élément tronconique dont la section circulaire augmente progressivement depuis le diamètre du câble 36 jusqu'à un diamètre final plus important au niveau de la jonction entre le passe-fil 58 et le corps 32. Le passe-fil 58 permet de rigidifier localement le câble 36 et d'éviter que le câble 36 ne rejoigne directement le corps 32, ce qui se traduirait par une concentration de contraintes lors de l'application d'un effort sur le câble 36 au niveau de la jonction entre le câble 36 et le corps 32. Des rainures 60 sont réparties en surface du passe-fil 58 de façon que le passe-fil 58 n'ait pas une rigidité trop importante. Selon une variante de réalisation de l'invention, des passes-fils peuvent également être prévus au niveau de la jonction entre chacun des câbles 20, 22, 24 et le dispositif de liaison 30.

A titre d'exemple, la longueur axiale 1 de chaque arbre 34 est de l'ordre de 2 mm et le diamètre d de chaque arbre 34 est de l'ordre de 2,5 mm. La rigidité du matériau constituant les paliers 38, 40 peut être supérieure à la rigidité du matériau constituant le dispositif de liaison 30. Le montage du dispositif de liaison 30 dans les paliers 38, 40 peut être réalisé par encliquetage. Une fois monté, l'extrémité libre de chaque arbre 34 se projette hors du palier 38, 40 correspondant d'une longueur d'au moins 0,5 mm. Ceci permet d'éviter que l'un des arbres 34 ne s'échappe de l'ouverture 42 du palier 38, 40 correspondant en se déformant lorsqu'un effort trop important est exercé sur le dispositif de liaison 30.

Les figures 4 et 5 représentent respectivement la position relative entre le lecteur 5 et le câble 36 lorsque le lecteur 5 est posé sur un support plan (par exemple, une table), non représenté, et lorsqu'un utilisateur, non représenté, prend en main le lecteur 5. Par rapport à la position représentée en figure 4, le dispositif de liaison 30 a, en figure 5, pivoté d'une trentaine de degrés dans le sens inverse des aiguilles d'une montre autour d'un axe horizontal. L'axe de pivotement du dispositif de liaison 30 est sensiblement perpendiculaire aux faces latérales 9, 10 du boîtier 6. Un tel axe est donc sensiblement parallèle à l'axe autour duquel un utilisateur a le plus de chances de faire pivoter le lecteur 5 lors d'une utilisation normale du lecteur 5. Lors d'une manipulation du lecteur 5, les efforts les plus importants sont appliqués au câble 36 au niveau de sa jonction avec le dispositif de liaison 30. Le dispositif de liaison 30 pivotant en fonction de l'inclinaison du lecteur 5, on réduit la courbure imposée au câble 36 au niveau de la jonction entre le câble 36 et le dispositif de liaison 30 et donc les efforts appliqués au câble 36. On réduit ainsi l'usure du câble 36.

Une inclinaison du dispositif de liaison 30 entraîne un déplacement des câbles 20, 22, 24. La longueur de chaque câble 20, 22, 24 doit donc être suffisante pour permettre le pivotement maximal souhaité du dispositif de liaison 30. A titre d'exemple, le pivotement maximal souhaité est de l'ordre de 30° à 40°. De façon générale, les bornes de connexion 14, 15, 16 sont disposées le plus loin possible du dispositif de liaison 30 de façon que les longueurs des câbles 20, 22, 24 soient les plus longues possibles. Ceci permet de diminuer les déformations subies par les câbles 20, 22, 24 lors d'un pivotement du dispositif de liaison 30 et donc les efforts appliqués aux câbles 20, 22, 24. En particulier, il est avantageux que la borne de connexion disposée le plus loin du dispositif de liaison 30 soit reliée au câble de plus gros diamètre qui a généralement la rigidité la plus élevée, de façon à réduire les déformations subies par le câble le plus rigide. Toutefois, les longueurs des câbles 20, 22, 24 ne doivent pas être trop importantes pour limiter l'encombrement au niveau de la partie arrière 12 et de la face inférieure 7 du boîtier 6. Un compromis doit donc être trouvé entre une augmentation de l'encombrement dû aux câbles 20, 22, 24 et la réduction des efforts appliqués à ceux-ci.

Dans le cas où le lecteur 5 comprend un rouleau de papier 62 protégé par un couvercle 64 pivotant, le couvercle 64 peut être ouvert, par exemple pour changer le rouleau de papier 62, lorsque le dispositif de liaison 30 est incliné, le câble 36 ne gênant alors pas l'ouverture du couvercle 64. Le dispositif de liaison 30 selon la présente invention permet d'obtenir une inclinaison du câble 36 par rapport au lecteur 5 au niveau de la "jonction" entre le câble 36 et le lecteur 5 plus importante que celle qui pourrait être obtenue si le câble 36 était directement connecté à une fiche située au niveau de la partie arrière 12 du lecteur 5. Le dispositif de liaison 30 peut donc être placé à proximité du couvercle 64 ce qui permet de réduire les dimensions du lecteur 5 au niveau de la partie arrière 12 du boîtier 6.

Selon le premier exemple de réalisation du dispositif de liaison selon l'invention, pour un utilisateur, seul un câble 36 unique est relié au lecteur 5. L'aspect visuel du lecteur 5 est ainsi amélioré par rapport à un lecteur classique pour lequel des câbles distincts sont connectés au lecteur 5. En outre, la manipulation du lecteur 10 est facilitée puisqu'on supprime les risques d'entremêlement des câbles lors de manipulations du lecteur 5.

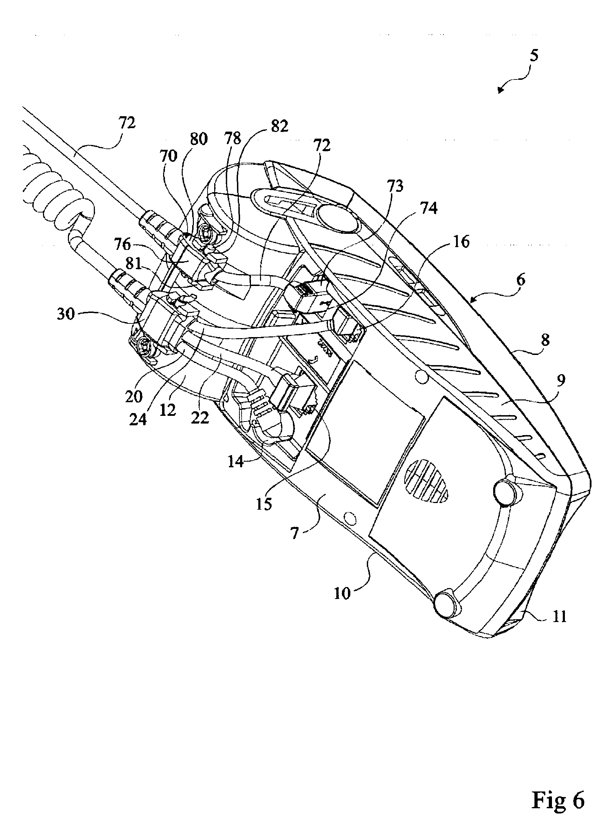

La figure 6 représente le lecteur 5 de la figure 1 pour lequel un dispositif de liaison 70 selon un second exemple de réalisation de l'invention est disposé de façon adjacente au dispositif de liaison 30. Le dispositif de liaison 70 est prévu au niveau d'un câble 72 dont une extrémité comporte une fiche 73 connectée à une borne de connexion 74 de forme complémentaire disposée au niveau de la face inférieure 7 du lecteur 5. La borne de connexion 74 est par exemple une borne USB. Le dispositif de liaison 70 a une structure analogue au dispositif de liaison 30 et comporte un corps 76 comprenant deux arbres cylindriques 78 concentriques disposés de part et d'autre du corps 76. Le boîtier 6 comprend deux paliers 80, 81 comprenant chacun une ouverture cylindrique 82 recevant un arbre 78. Le dispositif de liaison 70 est donc adapté à pivoter par rapport au boîtier 6 autour de l'axe défini par les arbres 78, c'est-à-dire d'un axe sensiblement perpendiculaire aux faces latérales 9, 10 du boîtier 6. Le second exemple de réalisation illustre le fait que le dispositif de liaison selon l'invention peut être associé à un seul câble.

Selon la présente invention, les bornes de connexion 14, 15, 16, 74 sont placées au niveau de la face inférieure 7 du boîtier 6 alors que, de façon classique, elles sont placées au niveau de la partie arrière 12 du boîtier 6. Une plus grande liberté est donc offerte pour disposer les bornes de connexion. En particulier, il n'est pas nécessaire de les aligner les unes à côté des autres, ce qui est généralement le cas lorsque les bornes de connexion sont disposées au niveau de la partie arrière 12 du lecteur 5. A titre d'exemple, en figure 6, les bornes de connexion 14, 15, 16, 74 sont réparties selon un "L". Ceci permet de réduire la largeur du lecteur 5.

Selon une variante de la présente invention, on peut prévoir en figure 6 un dispositif de liaison unique au niveau duquel sont connectés les quatre câbles 20, 22, 24 et 72, le câble unique 36 contenant alors également les fils conducteurs associés au câble 72. Toutefois, il peut être avantageux de prévoir des dispositifs de liaison 30, 70 séparés. En effet, le câble 72 peut n'être utile que pour certaines applications particulières du lecteur 5. Il est alors préférable qu'un tel câble ne soit présent que lorsqu'il est réellement utilisé. Lorsque le câble 72 n'est pas présent, comme cela est le cas en figure 1, un élément factice 84 peut être prévu au niveau des paliers 80, 81 à la place du dispositif de liaison 70.

Selon une autre variante de l'invention, le dispositif de liaison 30 permet en outre un pivotement autour d'un axe perpendiculaire aux faces supérieure 8 et inférieure 7 du boîtier 6, c'est-à-dire un axe sensiblement vertical lorsque le lecteur 5 est posé sur une surface horizontale. Ceci peut être intéressant pour réduire les contraintes exercées au niveau du câble 36 lorsqu'on déplace latéralement le lecteur 5. En effet, un tel mouvement tend à entraîner une flexion du câble 36 autour d'un axe perpendiculaire aux faces supérieure 8 et inférieure 7 du boîtier 6. De façon plus générale, le dispositif de liaison 30 peut correspondre à une rotule susceptible de pivoter autour de n'importe quel axe.

Bien entendu, la présente invention est susceptible de diverses variantes et modifications qui apparaîtront à l'homme de l'art. En particulier, bien que la présente invention ait été décrite pour un lecteur de cartes de paiement, elle peut s'appliquer à n'importe quel système électronique susceptible d'être déplacé par un utilisateur et relié à un autre élément par au moins un câble électrique. Il s'agit, par exemple, d'un ordinateur portable, d'une imprimante, d'une console de jeux vidéo, d'un lecteur audio, etc.

## Revendications

1. Câble électrique (20, 22, 24, 36 ; 72) destiné à être connecté à un système électronique (5) comprenant un boîtier (6), le câble électrique ayant une extrémité destinée à être électriquement connectée à une borne de connexion (14, 15, 16 ; 74) disposée au niveau du boîtier, et comprenant un dispositif de liaison (30 ; 70) du câble électrique au système électronique, **caractérisé en ce que** le dispositif de liaison est solidaire du câble électrique et comprend un moyen de liaison mécanique (34 ; 78) destiné à être relié à un moyen de liaison mécanique complémentaire (42 ; 82) du boîtier pour former une liaison pivotante.

2. Câble électrique selon la revendication 1, dans lequel le dispositif de liaison (30 ; 70) est constitué d'un matériau plastique et est formé par surmoulage sur le câble électrique.

3. Câble électrique selon la revendication 1, dans lequel le dispositif de liaison (30 ; 70) comprend un corps (32 ; 76) solidaire du câble électrique (20, 22, 24, 36 ; 72) et dans lequel le moyen de liaison (34 ; 78) comprend deux arbres cylindriques se projetant de part et d'autre du corps.

4. Câble électrique (20, 22, 24) selon l'une quelconque des revendications 1 à 3, comprenant :
une première portion de câble (20, 22, 24) ayant une première extrémité reliée au dispositif de liaison (30) et une seconde extrémité reliée à la borne de connexion (14, 15, 16) ;
une deuxième portion de câble (36) ayant une troisième extrémité reliée au dispositif de liaison ;
au moins un fil conducteur (50, 52, 54) s'étendant dans la première portion de câble, le dispositif de liaison et la deuxième portion de câble ;
une troisième portion de câble (20, 22, 24) ayant une quatrième extrémité reliée au dispositif de liaison et une cinquième extrémité destinée à être électriquement connectée à une borne de connexion supplémentaire (14, 15, 16) disposée au niveau d'un boîtier (6) ; et
au moins un fil conducteur supplémentaire (50, 52, 54) s'étendant dans la troisième portion de câble, le dispositif de liaison et la deuxième portion de câble.

5. Câble électrique selon la revendication 4, dans lequel les première et troisième portions de câble (20, 22, 24) sont reliées au dispositif de liaison (30) au niveau d'une première face du dispositif de liaison et dans lequel la deuxième portion de câble est reliée au dispositif de liaison au niveau d'une seconde face du dispositif de liaison opposée à la première face.

6. Système électronique (5) comprenant :
un boîtier (6) ;
une borne de connexion (14, 15, 16 ; 74) disposée au niveau du boîtier ;
un câble électrique (20, 22, 24, 36 ; 72) selon la revendication 1, ladite extrémité du câble électrique étant électriquement connectée à la borne de connexion, et le dispositif de liaison mécanique (30 ; 70) du câble électrique étant relié au boîtier.

7. Système électronique selon la revendication 6, dans lequel le câble électrique (20, 22, 24) comprend :
une première portion de câble (20, 22, 24) ayant une première extrémité reliée au dispositif de liaison (30) et une seconde extrémité reliée à la borne de connexion (14, 15, 16) ;
une deuxième portion de câble (36) ayant une troisième extrémité reliée au dispositif de liaison ;
au moins un fil conducteur (50, 52, 54) s'étendant dans la première portion de câble, le dispositif de liaison et la deuxième portion de câble ;
une troisième portion de câble (20, 22, 24) ayant une quatrième extrémité reliée au dispositif de liaison et une cinquième extrémité électriquement connectée à une borne de connexion supplémentaire (14, 15, 16) disposée au niveau d'un boîtier (6) ; et
au moins un fil conducteur supplémentaire (50, 52, 54) s'étendant dans la troisième portion de câble, le dispositif de liaison et la deuxième portion de câble.

8. Système électronique selon la revendication 6, dans lequel le boîtier (6) comprend une face inférieure (7), la face inférieure étant destinée à être au moins en partie en contact avec un support lorsque le boîtier est déposé sur le support, une face supérieure (8) opposée à la face inférieure, et deux faces latérales (9, 10) reliant la face inférieure à la face supérieure, le dispositif de liaison (30 ; 70) étant adapté à pivoter autour d'un axe perpendiculaire aux faces latérales.

9. Système électronique selon la revendication 6, dans lequel le dispositif de liaison (30 ; 70) comprend un corps (32 ; 76) solidaire du câble électrique (20, 22, 24, 36 ; 72) et deux arbres cylindriques (34 ; 78) se projetant de part et d'autre du corps, le boîtier comprenant deux paliers (38, 40 ; 80 , 81), chaque palier ayant une ouverture cylindrique (42 ; 82) recevant l'un des arbres.

10. Système électronique selon la revendication 6, dans lequel le boîtier (6) comprend une face inférieure (7), la face inférieure étant destinée à être au moins en partie en contact avec un support lorsque le boîtier est déposé sur le support, la borne de connexion (14, 15, 16 ; 74) étant située au niveau de la face inférieure.

## Claims

1. An electric cable (20, 22, 24, 36; 72) for connecting to an electronic system (5) comprising a package (6), the electric cable having one end to be electrically connected to a connection terminal (14, 15, 16; 74) arranged at the level of the package, and comprising a device (30; 70) for jointing the electric cable to the electronic system, **characterized in that** the jointing device is solidly attached to the electric cable and comprises mechanical joint means (34; 78) to be connected to complementary mechanical joint means (42; 82) of the package to form a hinged joint.

2. The electric cable of claim 1, wherein the jointing device (30; 70) is made of plastic and is formed by duplicate molding on the electric cable.

3. The electric cable of claim 1, wherein the jointing device (30; 70) comprises a body (32; 76) solidly attached to the electric cable (20, 22, 24, 36; 72) and wherein the joint means (34; 78) comprise two cylindrical shafts projecting on either side of the body.

4. The electric cable (20, 22, 24) of any of claims 1 to 3, comprising:
a first cable portion (20, 22, 24) having a first end connected to the jointing device (30) and a second end connected to the connection terminal (14, 15, 16);
a second cable portion (36) having a third end connected to the jointing device;
at least one electric wire (50, 52, 54) extending in the first cable portion, the jointing device, and the second cable portion;
a third cable portion (20, 22, 24) having a fourth end connected to the jointing device and a fifth end intended to be electrically connected to an additional connection terminal (14, 15, 16) arranged at the level of a package (6); and
at least one additional electric wire (50, 52, 54) extending in the third cable portion, the jointing device, and the second cable portion.

5. The electric cable of claim 4, wherein the first and third cable portions (20, 22, 24) are connected to the jointing device (30) at the level of a first surface of the jointing device and wherein the second cable portion is connected to the jointing device at the level of a second surface of the jointing device opposite to the first surface.

6. An electronic system (5), comprising:
a package (6);
a connection terminal (14, 15, 16; 74) arranged at the level of the package;
the electric cable (20, 22, 24, 36; 72) of claim 1, said end of the electric cable being electrically connected to the connection terminal, and the mechanical jointing device (30; 70) of the electric cable being connected to the package.

7. The electronic system of claim 6, wherein the electric cable (20, 22, 24) comprises:
a first cable portion (20, 22, 24) having a first end connected to the jointing device (30) and a second end connected to the jointing terminal (14, 15, 16);
a second cable portion (36) having a third end connected to the jointing device;
at least one electric wire (50, 52, 54) extending in the first cable portion, the jointing device and the second cable portion;
a third cable portion (20, 22, 24) having a fourth end connected to the jointing device and a fifth end intended to be electrically connected to an additional connection terminal (14, 15, 16) arranged at the level of a package (6); and
at least one additional electric wire (50, 52, 54) extending in the third cable portion, the jointing device, and the second cable portion.

8. The electronic system of claim 6, wherein the package (6) comprises a lower surface (7), the lower surface being intended to be at least partly in contact with a support when the package is laid on the support, an upper surface (8) opposite to the lower surface, and two lateral surfaces (9, 10) connecting the lower surface to the upper surface, the jointing device (30; 70) being capable of rotating around an axis perpendicular to the lateral surfaces.

9. The electronic system of claim 6, wherein the jointing device (30; 70) comprises a body solidly attached to the electric cable (20, 22, 24, 26; 72), and two cylindrical shafts (34; 78) projecting on either side of the body, the package comprising two bearings (38, 40; 80, 81), each bearing having a cylindrical opening (42; 82) receiving one of the shafts.

10. The electronic system of claim 6, wherein the package (6) comprises a lower surface (7), the lower surface being intended to be at least partly in contact with a support when the package is laid on the support, the connection terminal (14, 15, 16; 74) being located at the level of the lower surface.

## Patentansprüche

1. Ein elektrisches Kabel (20, 22, 24, 36; 72) zum Verbinden mit einem elektronischen System (5), das ein Gehäuse (6) aufweist, wobei das elektrische Kabel ein Ende zum elektrischen Verbinden mit einem Verbindungsanschluss (14, 15, 16; 74) hat, angeordnet auf der Höhe bzw. Ebene des Gehäuses, und ein Gerät (30; 70) aufweist zum Anschließen des elektrischen Kabels an das elektronische System, **dadurch gekennzeichnet, dass** das Anschlussgerät fest mit dem elektrischen Kabel verknüpft ist, und mechanische Verbindungsmittel (34; 78) aufweist zum Verbinden mit komplementären mechanischen Verbindungsmitteln (42; 82) des Gehäuses, um eine klappbare Verbindung zu bilden.

2. Elektrisches Kabel nach Anspruch 1, wobei das Anschlussgerät (30; 70) aus Plastik gemacht ist, und durch einen doppelten Abguss an dem elektrischen Kabel gebildet wird.

3. Elektrisches Kabel nach Anspruch 1, wobei das Anschlussgerät (30; 70) einen Körper (32; 76) aufweist, der fest verknüpft ist mit dem elektrischen Kabel (20, 22, 24, 36; 72) und wobei die Anschlussmittel (34; 78) zwei zylindrische Bolzen bzw. Wellen aufweist, die auf jeder Seite des Körpers herausragen.

4. Elektrisches Kabel (20, 22, 24) nach einem der Ansprüche 1 bis 3, das Folgendes aufweist:
Einen ersten Kabelteil (20, 22, 24) mit einem ersten Ende, das mit dem Anschlussgerät (30) verbunden ist, und mit einem zweiten Ende, das mit dem Verbindungsanschluss (14, 15, 16) verbunden ist;
einen zweiten Kabelteil (36) mit einem dritten Ende, das mit dem Anschlussgerät verbunden ist;
wenigstens einem elektrischen Draht (50, 52, 54), der in den ersten Kabelteil, das Anschlussgerät, und den zweiten Kabelteil hineinragt;
einen dritten Kabelteil (20, 22, 24) mit einem vierten Ende, das mit dem Anschlussgerät verbunden ist, und einem fünften Ende dazu gedacht zum elektrischen Verbinden mit einem zusätzlichen Verbindungsanschluss (14, 15 16) angeordnet auf der Höhe bzw. Ebene eines Gehäuses (6); und
wenigstens ein zusätzlicher elektrischer Draht (50, 52, 54), der in den dritten Kabelteil, das Anschlussgerät, und den zweiten Kabelteil hineinragt.

5. Elektrisches Kabel nach Anspruch 4, wobei die ersten und zweiten Kabelteile (20, 22, 24) verbunden sind, mit dem Anschlussgerät (30) auf der Höhe bzw. Ebene einer ersten Oberfläche des Anschlussgeräts und wobei der zweite Kabelteil verbunden ist mit dem Anschlussgerät auf der Höhe bzw. Ebene einer zweiten Oberfläche des Anschlussgeräts auf der gegenüberliegenden Seite der ersten Oberfläche.

6. Ein elektronisches System (5), das Folgendes aufweist:
ein Gehäuse (6);
ein Verbindungsanschluss (14, 15, 16; 74) angeordnet auf der Höhe bzw. Ebene des Gehäuses;
das elektrische Kabel (20, 22, 24, 36; 72) nach Anspruch 1, wobei das Ende des elektrischen Kabels elektrisch verbunden ist mit dem Verbindungsanschluss, und dem mechanischen Anschlussgerät (30; 70) des elektrischen Kabels, das mit dem Gehäuse verbunden ist.

7. Elektronisches System nach Anspruch 6, wobei das elektrische Kabel (20, 22, 24) Folgendes aufweist:
einen ersten Kabelteil (20, 22, 24) mit einem ersten Ende, das mit dem Anschlussgerät (30) verbunden ist und einem zweiten Ende, das mit dem Verbindungsanschluss (14, 15, 16) verbunden ist;
einem zweiten Kabelteil (36) mit einem dritten Ende, das mit dem Anschlussgerät verbunden ist;
wenigstens einem elektrischen Draht (50, 52, 54), das in den ersten Kabelteil, das Anschlussgerät und dem zweiten Kabelteil hineinragt;
einem dritten Kabelteil (20, 22, 24) mit einem vierten Ende, das mit dem Anschlussgerät verbunden ist und einem fünften Ende dazu gedacht zum elektrischen Verbinden mit einem zusätzlichen Verbindungsanschluss (14, 15, 16) angeordnet auf der Höhe bzw. Ebene eines Gehäuses (6); und
wenigstens einem zusätzlichen elektrischen Draht (50, 52, 54), das in den dritten Kabelteil, das Anschlussgerät und den zweiten Kabelteil hineinragt.

8. Elektronisches System nach Anspruch 6, wobei das Gehäuse (6) eine untere Oberfläche bzw. Ebene (7) aufweist, wobei die untere Oberfläche dazu gedacht ist, wenigstens teilweise mit einem Träger in Kontakt zu stehen, und zwar wenn das Gehäuse auf dem Träger gestellt wird, eine obere Oberfläche bzw. Ebene (8) aufweist, gegenüberliegend zu der unteren Oberfläche, und zwei laterale Oberflächen (9, 10) aufweist, die die untere Ebene mit der oberen Ebene verbinden, wobei das Anschlussgerät (30; 70) in der Lage ist um eine Achse zu rotieren, die zu den lateralen Oberflächen rechtwinklig ist.

9. Elektronisches System nach Anspruch 6, wobei das Anschlussgerät (30; 70) einen Körper aufweist, der fest mit dem elektrischen Kabel (20, 22, 24, 26; 72) verknüpft ist, und zwei zylindrische Bolzen bzw. Wellen (34; 78), die auf jeder Seite des Körpers herausragen, wobei das Gehäuse zwei Stützen (38, 40; 80, 81) aufweist, wobei jede Stütze eine zylindrische Öffnung (42; 82) hat, die einen der Bolzen bzw. Wellen empfängt.

10. Elektronisches System nach Anspruch 6, wobei das Gehäuse (6) eine untere Oberfläche (7) aufweist, wobei die untere Oberfläche dazu gedacht ist zum wenigstens teilweise mit einem Träger in Kontakt zu stehen, wenn das Gehäuse auf den Träger gestellt wird, wobei der Verbindungsanschluss (14, 15, 16; 74) auf der Höhe bzw. Ebene der unteren Oberfläche angeordnet ist.
